Europäisches Patentamt

European Patent Office

Office européen des brevets

(19)

(11) Veröffentlichungsnummer: **0 031 140**
**B1**

(12) **EUROPÄISCHE PATENTSCHRIFT**

(45) Veröffentlichungstag der Patentschrift:
17.04.85

(51) Int. Cl.⁴: **H 03 F 3/24,** H 03 F 1/34

(21) Anmeldenummer: **80107993.0**

(22) Anmeldetag: **17.12.80**

(54) Transistor-Breitbandverstärker mit einem jeweils gegengekoppelten Vor- und Endverstärker.

(30) Priorität: 21.12.79 DE 2951913
21.12.79 DE 2951935

(43) Veröffentlichungstag der Anmeldung:
01.07.81 Patentblatt 81/26

(45) Bekanntmachung des Hinweises auf die Patenterteilung:
17.04.85 Patentblatt 85/16

(84) Benannte Vertragsstaaten:
AT BE CH DE FR GB IT LI NL SE

(56) Entgegenhaltungen:
DE - A - 2 531 132
DE - B - 1 293 236
DE - B - 2 724 545

(73) Patentinhaber: Siemens Aktiengesellschaft, Berlin und München Wittelsbacherplatz 2, D-8000 München 2 (DE)

(72) Erfinder: Bartenstein, Peter, Ing. grad.,
Gabriele-Münter-Strasse 17, D-8000 München 71 (DE)
Erfinder: Hübner, Franz Richard, Ing. grad.,
Blaichacherstrasse 6, D-8000 München 71 (DE)
Erfinder: Mocha, Karl, Dipl.-Ing., Gutdelxlfurt 4,
D-8132 Tutzing (DE)
Erfinder: Gölz, Hubert, Dipl.-Ing., Glatzerstrasse 17,
D-8034 Germering (DE)

Anmerkung. Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

BUNDESDRUCKEREI BERLIN

## Beschreibung

Die Erfindung bezieht sich auf einen Transistor-Breitbandverstärker, bei dem ein gegengekoppelter, aus zwei Emitterstufen bestehender Vorverstärker und ein gegengekoppelter, dreistufiger Endverstärker, dessen erste beiden Transistorstufen Emitterstufen sind, in Kette geschaltet sind, wobei ein Gegenkopplungssignal des Ausganges des Vorverstärkers dem Eingang eines ersten Gegenkopplungsnetzwerks zugeführt ist, dessen Ausgangssignal mittels gemischter Serien-Parallel-Einspeisung in den Eingang des Vorverstärkers zurückgeführt ist und wobei ein gemischtes Serien-Parallel-Gegenkopplungssignal des Ausganges des Endverstärkers dem Eingang eines zweiten Gegenkopplungsnetzwerkes zugeführt ist, dessen Ausgangssignal mittels Serieneinspeisung in den Eingang des Endverstärkers zurückgeführt ist, wobei die Transistorstufen des Vorverstärkers und des Endverstärkers aus einer gemeinsamen Versorgungsspannungsquelle gespeist sind.

Ein derartiger Breitbandverstärker ist bereits aus der DE-AS 1 293 236 bekannt.

Bei dem bekannten Breitbandverstärker sind alle fünf Transistorstufen in Emitterschaltung geschaltet. Die Gegenkopplung des Vorverstärkers ist proportional zu dessen Ausgangsstrom.

Weiterhin ist bereits ein zweistufiger Transistorverstärker bekannt (DE-AS 2 724 545), der einen Eingangstransistor in Emitterschaltung und einen damit galvanisch gekoppelten Transistor der Endstufe in Basisschaltung enthält. Bei diesem Verstärker werden die Emitter-Kollektorstrecken beider Transistoren vom gleichen Strom durchflossen, indem sie in Reihenschaltung über einen Ausgang an eine Spannungsquelle angeschlossen sind. Die Ankopplung der als Treiberstufe dienenden Eingangsstufe an die Endstufe erfolgt über die Anzapfung eines als Sparübertrager ausgebildeten Zwischenübertragers.

Bei diesem Verstärker wird eine Verminderung der Stromaussteuerung der Treiberstufe erreicht, derart, daß dem relativ großen Signalstrom in der Endstufe ein kleinerer Signalstrom in der Treiberstufe entspricht. Hierdurch ergibt sich eine spürbare Verbesserung der Linearität des Verstärkers bei geringem Strombedarf. Wird jedoch darüber hinaus auch eine hohe Klemmenverstärkung bei hohen Frequenzen gefordert, so sind weitere Verstärkerstufen erforderlich.

Überlegungen im Rahmen der Erfindung haben ergeben, daß sich die gewünschte hohe Klemmenverstärkung bei einem Breitbandverstärker, der die genannte Endstufen-Konfiguration aufweist, bei hoher elektrischer Stabilität der Anordnung dann erzielen läßt, wenn man zwei Verstärkerblöcke mit jeweils hoher Schleifenverstärkung vorsieht und daß sich dabei der ersten Verstärkerblock vornehmlich mit Hinblick auf geringes Rauschen und der zweite Verstärkerblock vornehmlich mit Hinblick auf geringeres Klirren und eine hohe Aussteuerungsreserve optimieren läßt.

Aufgabe der Erfindung ist es, einen Transistor-Breitbandverstärker derart auszubilden, daß er besonders hohe Anforderungen hinsichtlich einer niedrigen Rauschzahl geringer linearer und nichtlinearer Verzerrungen erfüllt und dabei eine hohe Aussteuerungsreserve bei geringem Verbrauch an Gleichstromleistung aufweist. Insbesondere soll der Breitbandverstärker für eine Verwendung in Übertragungssystemen der Trägerfrequenz-Übertragungstechnik geeignet sein.

Gemäß der Erfindung wird der Breitbandverstärker zur Lösung dieser Aufgabe derart ausgebildet, daß die dritte Stufe des Endverstärkers als Transistorstufe in Basisschaltung ausgebildet ist, die über die Anzapfung eines als Sparübertrager ausgebildeten Zwischenübertragers derart an die zweite Transistorstufe angekoppelt ist, daß die zweite und die dritte Transistorstufe in Reihenschaltung über einen Ausgangswiderstand an die Versorgungsspannungsquelle angeschlossen sind, und daß das erste Gegenkopplungsnetzwerk derart an einen Ausgangsübertrager des Vorverstärkers angeschlossen ist, daß der durch das erste Gegenkopplungsnetzwerk gegebene Belastungswiderstand durch den Ausgangsübertrager hinauftransformiert wird.

Durch diese Maßnahmen ergibt sich der Vorteil, daß sich die genannten hohen Anforderungen bei einem Breitbandverstärker hoher Klemmenverstärkung sicher erfüllen lassen.

In weiterer Ausgestaltung der Erfindung wird bei einem eingangsseitigen Gabelübertrager, der eine erste Zahl von Windungen zwischen der Basis des ersten Transistors und einer Nachbildung, am Ausgang eines Gegenkopplungsnetzwerkes eine zweite Zahl von Windungen und zwischen den Eingangsklemmen des Breitbandverstärkers eine dritte Zahl von Windungen hat, das Verhältnis der ersten zur dritten Windungszahl derart bemessen, daß sich für den Eingangstransistor ein bezüglich Rauschen optimaler Generatorwiderstand ergibt und daß das Verhältnis der ersten zur zweiten Windungszahl möglichst groß gewählt ist, insbesondere derart, daß eine Belastung des Vorverstärkerausgangs mit einem zu niederohmigen Gegenkopplungsnetzwerk noch vermieden ist und parasitäre Elemente des Eingangsgabelübertragers noch ausreichend klein sind.

Durch diese Maßnahmen lassen sich eine besonders geringe Dämpfung zwischen dem Eingang des Breitbandverstärkers und der ersten Transistorstufe und Rauschanpassung für diese Stufe und damit besonders günstige Verhältnisse im Hinblick auf die Rauschzahl erzielen.

In weiterer Ausgestaltung der Erfindung wird bei einem ausgangsseitigen Gabelübertrager, der eine erste Zahl von Windungen zwischen dem Kollektor des dritten Transistors des Endverstärkers und einer Nachbildung, am Eingang eines Gegenkopplungsnetzwerkes eine zweite Zahl von Windungen und zwischen den Ausgangsklemmen des Breitbandverstärkers eine dritte Zahl von Windungen hat, das Verhältnis der ersten zur dritten Windungszahl derart bemessen, daß der sich ergebende Lastwiderstand des Endstufentransistors an das Verhältnis von Ruhespannung zu Ruhestrom des dritten Transistors des Endverstärkers angepaßt ist und daß das Verhältnis der ersten zur zweiten Windungszahl möglichst groß gewählt ist, insbesondere derart, daß die parasitären Elemente des Ausgangsgabelübertragers noch ausreichend klein sind.

Dabei ergibt sich in vorteilhafter Weise eine besonders geringe Dämpfung zwischen der Ausgangsstufe des Endverstärkers und dem Ausgang des Breitbandverstärkers und eine optimale Ausnutzung der im Endstufentransistor verfügbaren Gleichstromleitung, was im Hinblick auf Grenzpegel und Klirren besonders vorteilhaft ist.

Zweckmäßigerweise ist in dem Nachrichten-Übertragungssystem, für das der Breitbandverstärker bestimmt ist, eine Preemphase vorgesehen, um die Anforderungen an die Aussteuerbarkeit der Verstärker zu vermindern. Dieser Tatsache wird bei einem Breitbandverstärker, dem ein Vorentzerrer vorgeschaltet ist, das erste und das zweite Gegenkopplungsnetzwerk als erster bzw. zweiter Gegenkopplungsentzerrer ausgebildet sind und zwischen dem Vor- und dem Endverstärker ein Zwischenentzerrer eingefügt ist, zweckmäßigerweise dadurch Rechnung getragen, daß mindestens der Teil des Verstärkungsfrequenzganges, der einem vorgegebenen Preemphasenfrequenzgang entspricht, mit Hilfe der beiden Gegenkopplungsentzerrer und des Zwischenentzerrers realisiert ist.

Der Vorentzerrer wird zweckmäßigerweise derart ausgebildet, daß er praktisch nur bei tiefen Frequenzen eine Dämpfung und bei hohen Frequenzen zumindest nahezu keine Dämpfung aufweist.

Durch diese Maßnahmen ergibt sich, daß die Grundgeräuschleistung bei tiefen Frequenzen nicht größer als bei hohen Frequenzen ist.

Insgesamt, d. h. einschließlich der Vorentzerrerdämpfung, muß wegen des Wurzelfrequenzganges der Leitungsdämpfung die Verstärkung bei tiefen Frequenzen viel niedriger sein als bei hohen Frequenzen. Ausgehend von der Erkenntnis, daß es an sich genügt, wenn die vom Verstärker erzeugte Rauschleistung bei tiefen Frequenzen ebenso niedrig oder etwas niedriger als bei hohen Frequenzen ist und es daher nicht zweckmäßig ist, an dieser Stelle erheblich mehr Frequenzgang zu bewirken, wird dieser Frequenzgang zweckmäßigerweise nur zum Teil in den Verstärkern selbst realisiert.

Der Rest des zu erzeugenden Frequenzganges wird somit in einem Vorentzerrer realisiert, der nur bei tiefen Frequenzen eine Dämpfung verursacht und im oberen Frequenzbereich nahezu keine Dämpfung hat. Auf diese Weise ergibt sich der Vorteil, daß weniger Leistung an den Verstärker-Eingang gelangt und dieser auch bei einem relativ niedrigen Strom in der Eingangsstufe praktisch nicht klirrt.

Zweckmäßigerweise sind die Spannungsverstärkungen des Vorverstärkers und des Endverstärkers zumindest annähernd gleich groß.

Eine derartige Bemessung hat den Vorteil, daß die Verstärkung des Vorverstärkers nicht größer als nötig bzw. der Ausgangspegel noch so niedrig ist, daß die Ausgangsstufe des Vorverstärkers und die Eingangsstufe des Endverstärkers bei vorgegebener Gesamtverstärkung besonders wenig Gleichstromleistung brauchen.

Im Hinblick auf geringe Leistungsverluste im Eingangsgabelübertrager ist ein relativ hoher Eingangswiderstand des Entzerrernetzwerkes günstig. Mit Rücksicht hierauf und im Hinblick auf eine geringe Belastung der zweiten Stufe des Vorverstärkers hat sich dabei eine Ausbildung des Breitbandverstärkers erwiesen, bei der das erste, insbesondere als Gegenkopplungsentzerrer ausgebildete Gegenkopplungsnetzwerk durch einen Spannungsteiler gebildet ist, der über einen Übertrager parallel zum Ausgang des Vorverstärkers angekoppelt wird. Dies führt zu einem niederohmigen Ausgangswiderstand des Vorverstärkers. Für den Endverstärker erhält man durch Serieneinspeisung des Gegenkopplungssignals in den Eingang einen hochohmigen Eingangswiderstand.

Zweckmäßigerweise wird der Zwischenentzerrer als Spannungsteiler derart ausgebildet, daß er bei tiefen Frequenzen zumindest ebenso hochohmig ist wie bei hohen Frequenzen. Zweckmäßigerweise dämpft der Zwischenentzerrer bei tiefen Frequenzen mehr als bei hohen Frequenzen. Hätte man auf beiden Seiten eines derartigen Zwischenentzerrers einen Abschlußwiderstand, der gegen unendlich geht, so wäre ein in einem Querzweig liegender Zweipol als Zwischenentzerrer notwendig, der bei tiefen Frequenzen niederohmiger sein müßte als bei hohen, so daß sich bei tiefen Frequenzen, bei denen die Spannung an dieser Stelle immer noch höher sein kann als bei hohen, ein umso größerer Strom ergeben würde, was einen entsprechend größeren Gleichstrom in der zweiten Stufe voraussetzt.

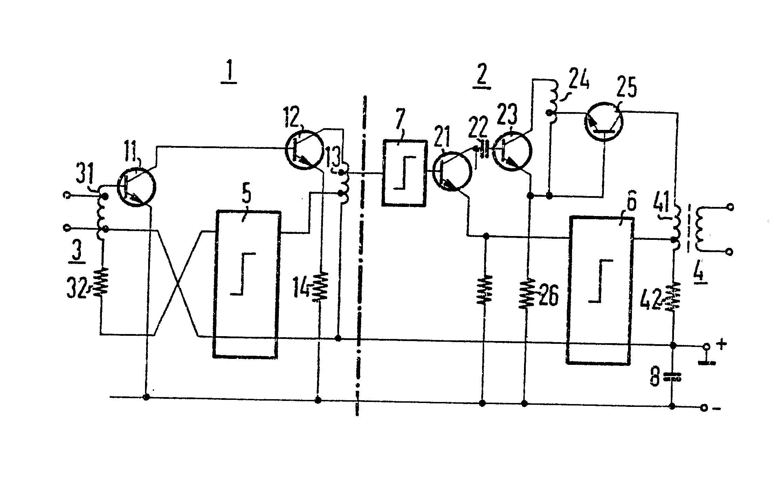

Die Erfindung wird anhand des in der Figur dargestellten Ausführungsbeispieles näher erläutert.

Die Figur zeigt einen aus einem Vor- und einem Endverstärker bestehenden Breitbandverstärker.

Der in der Figur gezeigte Breitbandverstärker bzw. TF-Leitungsverstärker ist eine Kettenschaltung aus zwei jeweils in sich stark gegengekoppelten Verstärkerblöcken.

Der Vorverstärker 1 enthält zwei Transistorstufen mit den Transistoren 11 und 12, der Endverstärker 2 dagegen drei Transistorenstufen mit den Transistoren 21, 23 und 25. Alle Transistoren, mit Ausnahme des in der letzten Endverstärkerstufe enthaltenen Transistors 25, sind in Emitterschaltung betrieben. Der Transistor 25 der letzten Stufe des Endverstärkers 2 ist in Basisgrundschaltung geschaltet.

Die beiden Transistorstufen des Vorverstärkers 1 und die beiden letzten Stufen des Endverstärkers sind jeweils gleichstrommäßig miteinander gekoppelt. Dagegen ist sowohl zwischen dem Vorverstärker 1 und dem Endverstärker 2 sowie zwischen der ersten und zweiten Stufe des Endverstärkers 2 jeweils eine gleichstrommäßige Potentialtrennung vorgesehen. Diese Potentialtrennung ist im dargestellten Beispiel im Zwischenentzerrer 7 bzw. mittels des Abblockkondensators 22 realisiert und ermöglicht es, den Arbeitspunkt der betreffenden Stufen jeweils unabhängig voneinander einzustellen. Die zur Arbeitspunkteinstellung der Verstärkerstufen erforderlichen Schaltmittel, z. B. Basisspannungsteiler, Basisvorwiderstände oder dgl., können in bekannter Weise ausgebildet werden und sind daher in der Figur nicht näher dargestellt. Die beiden letzten Stufen des Endverstärkers 2 erhalten mit Rücksicht auf den gewünschten geringen Leistungsverbrauch zweckmäßigerweise einen gemeinsamen Spannungsteiler zur Erzeugung der für beiden Transistoren 23 und 25 benötigten Basisvorspannung.

Die Versorgungsspannung liegt am Kondensator 8, der für die zu verstärkenden Wechselstromsignale einen Kurzschluß darstellt. Der mit dem Pluspol der Speisespannung verbundene Anschluß ist an Nullpotential bzw. Erde gelegt. Gegebenenfalls kann anstelle des Pluspols der Minuspol an Erde liegen.

Der Eingang des Vorverstärkers 1 ist durch gemischte Gegenkopplung mit Hilfe einer verlustarmen Sparübertragerverzweigung angepaßt. Der Eingangsgabelübertrager 3 ist als Sparübertrager ausgebildet, der eine erste Zahl $n_1$ von Windungen zwischen der Basis des ersten Transistors 1 und der Nachbildung 32 hat. Am Ausgang des ersten Gegenkopplungsnetzwerkes 5 liegt eine zweite Zahl $n_2$ von Windungen. Zwischen den Eingangsklemmen des Breitbandverstärkers liegt eine dritte Zahl $n_3$ von Windungen. Das Übersetzungsverhältnis $n_1 : n_2$ des eingangsseitigen Gabelübertragers 3 ist unter Berücksichtigung gewisser Grenzen so groß wie möglich gewählt. Die Grenzen ergeben sich aus der Forderung, den Ausgang des Vorverstärkers nicht mit einem zu niederohmigen Gegenkopplungsnetzwerk zu belasten und aus der Forderung, die parasitären Elemente des Übertragers ausreichend klein zu halten.

Das Übersetzungsverhältnis $n_1 : n_3$ wird zweckmäßigerweise so gewählt, daß sich für den Eingangstransistor ein bezüglich Rauschen optimaler Generatorwiderstand ergibt.

Der erste Transistor 11 des Vorverstärkers 1 wird durch die Wicklung 31 des Eingangsgabelübertragers 3 gespeist. Zum Zwecke der gemischten Serien-Parallel-Einspeisung des Gegenkopplungssignals in den Eingang des Vorverstärkers ist eine Anzapfung der Wicklung 31 mit dem Nullpotential (Erde) verbunden und der Fußpunkt der Wicklung 31 über den ohmschen Widerstand 32 an den Ausgang des ersten Gegenkopplungsnetzwerks 5 angeschlossen. Durch diese Art der aktiven Anpassung des Eingangswiderstandes läßt sich in bekannter Weise am Eingangsgabelübertrager 3 ein definierter Eingangsscheinwiderstand erzielen, an den ein vorgeschalteter, in der Figur nicht dargestellter Vorentzerrer angepaßt ist.

Der Ruhestrom im Transistor 11 ist so gewählt, daß sich ein minimales Rauschen ergibt. Der Vorentzerrer ermöglicht eine derartige Wahl des Ruhestromes bzw. der Verstärkung der ersten Stufe, daß der Rauschbeitrag des Transistors 12 vernachlässigbar klein ist. Ferner hat der Vorverstärker 1 eine derartige Verstärkung, daß der Rauschbeitrag des Endverstärkers 2 praktisch nicht ins Gewicht fällt.

Der zweite Transistor 12 des Vorverstärkers 2 ist kollektorseitig über den Sparübertrager 13 an Nullpotential geführt. Der Sparübertrager 13 hat zwei Abgriffe. Zwischen einem ersten Abgriff und Nullpotential liegt eine erste Zahl, zwischem einem zweiten Abgriff und Nullpotential eine demgegenüber größere zweite Zahl von Windungen.

Die Gegenkopplungsspannung des Eingangsverstärkers 1 wird zwischen dem ersten Abgriff des Sparübertragers 13 und Nullpotential abgenommen und dem Gegenkopplungsnetzwerk 5 zugeführt. Durch diese Art der Auskopplung des Gegenkopplungssignals ergibt sich eine zur Ausgangsspannung des Vorverstärkers 1 proportionale Gegenkopplung. Vom Eingangsgabelübertrager 3 ins Gegenkopplungsnetzwerk 5 hinein gesehen ergibt sich dabei ein höherer Widerstand, als wenn die Schleifengegenkopplung zum Ausgangsstrom proportional wäre. Die vorgesehene Art der Gegenkopplung liefert somit einen wesentlichen Beitrag zu der gewünschten kleinen Rauschzahl.

Der erste Transistor 21 des Endverstärkers 2 ist mit seiner Basis über einen im Zwischenentzerrer 7 enthaltenen, in der Figur nicht dargestellten Abblockkondensator an den zweiten Abgriff des Übertragers 13 angeschlossen.

Zwischen dem ersten und dem zweiten Verstärkerblock ist ein zusätzliches Zwischenentzerrernetzwerk eingeschaltet. Dieser Zwischenentzerrer 7 bewirkt auch eine Potentialtrennung und kann gegebenenfalls durch einen Abblockkondensator ersetzt werden.

Die Endstufe des Endverstärkers 2 ist in Basisschaltung aufgebaut, die nicht durch starke Eigengegenkopplung mit Impedanzen Leistung verliert. Die Basisschaltung hat keine Stromverstärkung. Daher führt der Transistor 23 der Treiberstufe annähernd den gleichen Gleichstrom wie der Transistor 25 der Endstufe. Insbesondere werden die Emitter-Kollektorstrecken beider Transistoren vom gleichen Strom durchflossen, indem sie in an sich bekannter Weise in Reihenschaltung über einen Ausgang an eine Spannungsquelle angeschlossen sind.

Die Ankopplung der Treiberstufe an die Endstufe erfolgt über die Anzapfung des Sparübertragers 24, so daß Unteraussteuerung bezüglich
des Stromes der Treiberstufe herrscht. Die Treiber- und die Endstufe werden insbesondere so
optimiert, daß die Spannungsamplitude am Ausgang der Treiberstufe nicht zu groß ist und die
Treiberstufe mit einer relativ kleinen Kollektor-
Emitterspannung betrieben wird. Diese Maßnahmen führen zu einer sehr hohen Klirrdämpfung
bei relativ geringem Leistungsbedarf.

Es besteht Übertragerkopplung zwischen der
Treiber- und der Endstufe. Diese beiden Stufen
sind galvanisch derart miteinander verbunden,
daß beide vom Versorgungsgleichstrom in Serie
durchflossen werden.

Der Endverstärker 2 ist am Ausgang durch gemischte Gegenkopplung mit Hilfe einer Übertragerverzweigung angepaßt. Am Eingang ist der
Endverstärker 2 durch reine Seriengegenkopplung hochohmig.

Im Kollektorkreis des letzten Transistors 25
des Endverstärkers 2 liegt die Primärwicklung
des Ausgangsgabelübertragers 4, dessen Sekundärwicklung den Ausgang des gesamten
Breitbandverstärkers darstellt.

Zum Zwecke einer gemischten Serien-Parallel-Auskopplung des Gegenkopplungssignals ist
der Fußpunkt der Primärwicklung 41 des Ausgangsgabelübertragers 4 über die Nachbildung
42 mit dem Nullpotential verbunden. Eine Anzapfung der Primärwicklung 41 ist an den Eingang
des zweiten Gegenkopplungsnetzwerkes 6 geführt. Die zwischen den Ausgangsklemmen des
zweiten Gegenkopplungsnetzwerkes 6 wirksame
Impedanz, über die der Emitter des Transistors
21 an Nullpotential geführt ist, bewirkt für die
erste Stufe des Endverstärkers eine Eigengegenkopplung.

Das Übersetzungsverhältnis $m_1 : m_2$ des ausgangsseitigen Gabelübertragers wird unter Berücksichtigung bestimmter Grenzen so groß wie
möglich gewählt. Die Grenzen ergeben sich aus
der Forderung, die parasitären Elemente des
Übertragers ausreichend klein zu halten. Das
Übersetzungsverhältnis $m_1 : m_3$ ist so gewählt,
daß der sich ergebende Lastwiderstand des
Endstufentransistors 25 an das Verhältnis von
Ruhespannung zu Ruhestrom des Endstufentransistors 25 angepaßt ist.

In jedem der beiden Verstärkerblöcke wird nur
eine Gabelverzweigung für aktive Anpassung,
nämlich am Eingang des Vorverstärkers und am
Ausgang des Endverstärkers benötigt. Da ferner
zwischen beiden Verstärkerblöcken keine Anpassung vorgesehen ist, kann für die Schleifenverstärkung eine relativ große Streuinduktivität
der Gabelübertrager und damit ein besonders
großes Übersetzungsverhältnis der Gabelübertrager zugelassen werden. Dies wird dazu ausgenutzt, um eine möglichst geringe Dämpfung zwischen dem Eingang und erster Transistorstufe
und zwischen der Ausgangsstufe des Endverstärkers und dem Verstärkerausgang zu erzielen.

Der Eingang des Endverstärkers ist durch Gegenkopplung hochohmig. Da der Vorverstärker
somit über den als Spannungsteiler ausgebildeten Zwischenentzerrer auf einen hochohmigen
Lastwiderstand arbeitet, kann der Spannungsteiler selbst relativ hochohmig sein, was für den
Strombedarf der zweiten Stufe im Vorverstärker
vorteilhaft ist. Dabei wirkt die erste Stufe im
Endverstärker 2 als Basisstufe in der
Gegenkopplungsschleife, was für die Stabilität
vorteilhaft ist.

Da alle Transistorstufen über Stromzuführungswiderstände parallel an der gleichen
Stromversorgungsspannung liegen, wird die maximal notwendige Spannung von der gleichstrommäßigen Serienschaltung der zweiten und
der dritten Stufe im Endverstärker 2 bestimmt.
Damit ist selbst bei der vorgesehenen Minimierung der für diese beiden Stufen erforderlichen
Versorgungsspannung für alle vorangehenden
Stufen eine ausreichende Reserve der Versorgungsspannung verfügbar. Leistung sparen
heißt somit Strom sparen. Der Vorverstärker 1 ist
daher so ausgelegt, daß der vornehmlich eine
Spannungsverstärkung bewirkt und nur eine mäßige Stromverstärkung. Durch die der Ausgangsspannung des Vorverstärkers 1 proportionale Gegenkopplung erhält man hinsichtlich der
Gegenkopplungsschleife eine Stufe in Basisschaltung und eine in Emitterschaltung, wobei
sich die günstigen HF-Eigenschaften der Basisschaltung vorteilhaft auswirken. Streuimpedanzen des Eingangsgabelübertragers 3 werden nur
von dem relativ geringen Basiswechselstrom des
Transistors 11 der ersten Stufe durchflossen und
stören daher weniger, als wenn sie im Hauptweg
der Gegenkopplungsschleife liegen würden. Die
günstigen Bedingungen für die Stabilität des
Vorverstärkers 1 ermöglichen es, für den Vorverstärker 1 einen Ausgangsübertrager 13 einzuführen, mit dem erreicht wird, daß der durch das
Gegenkopplungsentzerrernetzwerk    gegebene
Belastungswiderstand der zweiten Stufe zusätzlich hochohmiger wird. Auch dies führt zu einem
geringeren Strombedarf.

Die spannungsproportionale Gegenkopplung
im Vorverstärker 1 ergibt, daß der Ausgangswiderstand des Vorverstärkers 1 niederohmig ist
bzw. gegen null geht. Da andererseits der Eingangswiderstand des Endverstärkers 2 gegen
den Wert unendlich geht, kann der Zwischenentzerrer 7 — insbesondere bei räumlich geringem
Abstand der beiden Verstärkerblöcke, z. B. auf
einer gemeinsamen Ätzplatte — als einfacher
Spannungsteiler aufgebaut werden, der vorzugsweise so ausgeführt wird, daß er als Last für
den zweiten Transistor 12 bei tiefen Frequenzen
— wo man trotz der geschilderten Maßnahmen
normalerweise noch einen höheren Pegel haben
kann — zumindest nicht niederohmiger wirkt als
bei hohen Frequenzen.

## Patentansprüche

1. Transistor-Breitbandverstärker, bei dem ein gegengekoppelter, aus zwei Emitterstufen bestehender Vorverstärker (1) und ein gegengekoppelter, dreistufiger Endverstärker (2), dessen erste beiden Transistorstufen Emitterstufen sind, in Kette geschaltet sind, wobei ein Gegenkopplungssignal des Ausganges des Vorverstärkers dem Eingang eines ersten Gegenkopplungsnetzwerks (5) zugeführt ist, dessen Ausgangssignal mittels gemischter Serien-Parallel-Einspeisung in den Eingang des Vorverstärkers zurückgeführt ist und wobei ein gemischtes Serien-Parallel-Gegenkopplungssignal des Ausganges des Endverstärkers dem Eingang eines zweiten Gegenkopplungsnetzwerkes (6) zugeführt ist, dessen Ausgangssignal mittels Serieneinspeisung in den Eingang des Endverstärkers zurückgeführt ist, wobei die Transistorstufen des Vorverstärkers und des Endverstärkers aus einer gemeinsamen Versorgungsspannungsquelle gespeist sind, dadurch gekennzeichnet, daß die dritte Stufe des Endverstärkers (2) als Transistorstufe in Basisschaltung ausgebildet ist, die über die Anzapfung eines als Sparübertrager (24) ausgebildeten Zwischenübertragers derart an die zweite Transistorstufe angekoppelt ist, daß die zweite und die dritte Transistorstufe in Reihenschaltung über einen Ausgangswiderstand an die Versorgungsspannungsquelle angeschlossen sind, und daß das erste Gegenkopplungsnetzwerk (5) derart an einen Ausgangsübertrager (13) des Vorverstärkers (1) angeschlossen ist, daß der durch das erste Gegenkopplungsnetzwerk (5) gegebene Belastungswiderstand durch den Ausgangsübertrager (13) hinauftransformiert wird.

2. Transistor-Breitbandverstärker nach Anspruch 1, dadurch gekennzeichnet, daß bei einem eingangsseitigen Gabelübertrager, der eine erste Zahl ($n_1$) von Windungen zwischen der Basis des ersten Transistors (11) und einer Nachbildung (32), am Ausgang eines Gegenkopplungsnetzwerkes eine zweite Zahl ($n_2$) von Windungen und zwischen den Eingangsklemmen des Breitbandverstärkers eine dritte Zahl ($n_3$) von Windungen hat, das Verhältnis der ersten zur dritten Windungszahl derart bemessen ist, daß sich für den Eingangstransistor ein bezüglich Rauschen optimaler Generatorwiderstand ergibt und daß das Verhältnis der ersten zur zweiten Windungszahl möglichst groß gewählt ist.

3. Transistor-Breitbandverstärker nach Anspruch 1 oder 2, dadurch gekennzeichnet, daß bei einem ausgangsseitigen Gabelübertrager (4), der eine erste Zahl ($m_1$) von Windungen zwischen dem Kollektor des dritten Transistors (25) des Endverstärkers (2) und einer Nachbildung (42), am Eingang eines Gegenkopplungsnetzwerkes (6) eine zweite Zahl ($m_2$) von Windungen und zwischen den Ausgangsklemmen des Breitbandverstärkers eine dritte Zahl ($m_3$) von Windungen hat, das Verhältnis der ersten zur dritten Windungszahl derart bemessen ist, daß der sich ergebende Lastwiderstand des Endstufentransistors an das Verhältnis von Ruhespannung zu Ruhestrom des dritten Transistors (25) des Endverstärkers (2) angepaßt ist und daß das Verhältnis der ersten zur zweiten Windungszahl möglichst groß gewählt ist.

4. Transistor-Breitbandverstärker nach Anspruch 1, wobei dem Breitbandverstärker ein Vorentzerrer vorgeschaltet ist, das erste und das zweite Gegenkopplungsnetzwerk als erster bzw. zweiter Gegenkopplungsentzerrer ausgebildet sind und zwischen dem Vor- und dem Endverstärker ein Zwischenentzerrer eingefügt ist, dadurch gekennzeichnet, daß mindestens der Teil des Verstärkungsfrequenzganges, der einem vorgegebenen Preemphasefrequenzgang entspricht, mit Hilfe der beiden Gegenkopplungsentzerrer (5, 6) und des Zwischenentzerrers (7) realisiert ist.

5. Transistor-Breitbandverstärker nach Anspruch 1 bis 4, dadurch gekennzeichnet, daß die Spannungsverstärkungen des Vorverstärkers und des Endverstärkers zumindest annähernd gleich groß sind.

6. Transistor-Breitbandverstärker nach einem der Ansprüche 1 bis 5, dadurch gekennzeichnet, daß das erste, insbesondere als Gegenkopplungsentzerrer ausgebildete Gegenkopplungsnetzwerk (5) durch einen Spannungsteiler gebildet ist, der über einen Übertrager parallel zum Ausgang des Vorverstärkers (1) angekoppelt ist.

7. Transistor-Breitbandverstärker nach einem der Ansprüche 1 bis 6, dadurch gekennzeichnet, daß der Zwischenentzerrer (7) als Spannungsteiler derart ausgebildet ist, daß er bei tiefen Frequenzen zumindest ebenso hochohmig ist wie bei hohen Frequenzen.

## Claims

1. A wide-band transistor amplifier, wherein a preliminary amplifier (1) with negative feedback consists of two common-emitter stages is connected in cascade with a three-stage output amplifier (2) with negative feedback whose first two stages are common-emitter stages, a negative feedback signal from the output of the preliminary amplifier is fed to the input of a first negative feedback network (5) whose output signal is returned as a mixed series-parallel input to the input of the preliminary amplifier, and where a mixed series-parallel negative feedback signal from the output of the three-stage amplifier is fed to the input of a second negative feedback network (6) whose output signal is returned as a series input to the input of the three-stage amplifier, where the transistor stages of the preliminary amplifier and of the output amplifier are fed from a common supply voltage source, characterised in that the third stage of the output amplifier (2) is a common base transistor stage coupled via the tapping of an intermediate transformer, designed as an autotransformer (24), to the second transistor stage in such manner that the second and third transistor stages are connected in a series arrangement via an output resistor to the supply voltage source, and that the first negative feedback network (5) is connected to an output transformer (13) of the preliminary amplifier (1) in such manner that the load impedance formed by the first negative feedback network (5) is stepped-up by the output transformer (13).

2. A wide-band transistor amplifier as claimed in Claim 1, characterised in that in the case of an input-end hybrid transformer which has a first number ($n_1$) of turns between the base of the first transistor (11) and a balancing network (32), a second number ($n_2$) of turns at the output of a negative feedback network, and a third number ($n_3$) of turns between the input terminals of the wide-band amplifier, the ratio of the first to the third number is contrived to be such that a generator impedance which is the optimum in respect of noise is obtained for the input transistor, and that the ratio of the first to the second number is selected to be as large as possible.

3. A wide-band transistor amplifier as claimed in Claim 1 or Claim 2, characterised in that in the case of an output-end hybrid transformer (4) which has a first number ($m_1$) of turns between the collector of the third transistor (25) of the output amplifier (2) and a balancing network (42), a second number ($m_2$) of turns at the input of a negative feedback network and a third number ($m_3$) of turns between the output terminals of the wide-band amplifier, the ratio of the first to the third number is contrived to be such that the resultant load impedance of the output stage transistor is matched to the ratio of rest voltage to rest current of the third transistor (25) of the output amplifier (2), and that the ratio of the first to the second number of turns is selected to be as large as possible.

4. A wide-band transistor amplifier as claimed in Claim 1, where the wide-band amplifier is preceded by a pre-equaliser, the first and second negative feedback networks are designed as respective first and second negative feedback equalisers and an intermediate equaliser is interposed between the preliminary amplifier and the output amplifier, characterised in that at least that part of the amplification frequency response which corresponds to a predetermined pre-emphasis frequency response is constructed with the assistance of the two negative feedback equalisers (5, 6) and the intermediate equaliser (7).

5. A wide-band transistor amplifier as claimed in Claim 1 to 4, characterised in that the voltage amplifications of the preliminary amplifier and of the output amplifier are at least approximately equal.

6. A wide-band transistor amplifier as claimed in one of Claims 1 to 5, characterised in that the first negative feedback network (5), which is designed as a negative feedback equaliser, is formed by a voltage divider coupled via a transformer parallel to the output of the preliminary amplifier (1).

7. A wide-band transistor amplifier as claimed in one of Claims 1 to 6, characterised in that the intermediate equaliser (7) is designed as a voltage divider in such manner that it is at least equally highly ohnic at low frequencies as at high frequencies.

## Revendications

1. Amplificateur à large bande à transistors, dans lequel un préamplificateur (1) couplé par contre-réaction et constitué par deux étages en émetteur commun et un amplificateur final (2), couplé par contre-réaction comportant trois étages, et dont les deux premiers étages à transistors sont des montages en émetteur commun, sont branchés selon un montage itératif, et un signal de contre-réaction de la sortie de l'amplificateur aboutissant à l'entrée d'un premier réseau de contre-réaction (5) dont le signal de sortie est renvoyé, au moyen d'une alimentation série-parallèle mixte à l'entrée du préamplificateur, et dans lequel un signal de contre réaction série-parallèle mixte de la sortie de l'amplificateur final est envoyé à l'entrée d'un second réseau de contre-réaction (6) , dont le signal de sortie est renvoyé par l'intermédiaire d'une alimentation série à l'entrée de l'amplificateur final, les étages à transistors du préamplificateur et de l'amplificateur final étant alimentés à partir d'une source commune de tension d'alimentation, caractérisé par le fait que le troisième étage de l'amplificateur final (2) est réalisé sous la forme d'un étage à transistors en montage en base commune, qui est accouplé par l'intermédiaire de la prise d'un transformateur intermédiaire réalisé sous la forme d'un autotransformateur (24) au second étage à transistor de telle sorte que le second et le troisième étage à transistors, branchés selon un montage série, sont raccordés par l'intermédiaire d'une résistance de sortie à la source de tension d'alimentation, et que le premier réseau de contre-réaction (5) est raccordé à un transformateur de sortie (13) du préamplificateur (1) de manière que la résistance de charge, fomré par le premier réseau de contre-réaction (5), est accrue par transformation par le transformateur de sortie (5).

2. Amplificateur à large bande à transistors, suivant la revendication 1, caractérisé par le fait que dans le cas d'un transformateur différentiel situé du côté entrée, et qui possède un premier nombre ($n_1$) de spires entre la base du premier transistor (11) et un équilibreur (32), un second nombre ($n_2$) de spires à la sortie d'un réseau de contre-réaction et un troisième nombre ($n_3$) de spires entre les bornes d'entrée de l'amplificateur à large bande, le rapport du premier au troisième nombre de spires est dimensionné de telle sorte que l'on obtient pour le transistor d'entrée une résistance d'attaque optimale du point de vue du bruit et que le rapport du premier au second nombre de spires est choisi aussi élevé que possible.

3. Amplificateur à large bande à transistors, suivant la revendication 1 ou 2, caractérisé par le fait que dans le cas d'un transformateur différentiel (4) situé du côté sortie, qui comporte un premier nombre ($m_1$) de spires entre le collecteur du troisième transistor (25) de l'amplificateur final (2) et un équilibreur (42), un second nombre ($m_2$) de spires à l'entrée d'un réseau de contre-réaction et un troisième nombre ($m_3$) de spires entre les bornes de sortie de l'amplificateur à large bande, le rapport du premier au troisième nombre de spires est dimensionné de telle manière que la résistance de charge obtenue pour le transistor de l'étage final est adapté au rapport de la tension de repos au courant de repos du troisième transistor (25) de l'amplificateur final (2) et que le rapport du premier au troisième nombre de spires est choisi aussi élevé que possible.

4. Amplificateur à large bande à transistor, suivant la revendication 1, dans lequel un précorrecteur de distorsions est branché en amont de l'amplificateur à large bande, le premier et le second réseau de contre-réaction sont réalisés en tant que premier et second correcteurs de distorsion à contre-réaction et in correcteur intermédiaire de distorsion est inséré entre le préamplificateur et l'amplificateur final, caractérisé par le fait qu'au moins la partie de la courbe de réponse en fréquence d'amplification, qui correspond à une courbe de réponse en réponse en fréquence prédéterminée de préaccentuation, est réalisée à l'aide des deux correcteurs de distorsions à contre-réaction (5, 6) et du correcteur intermédiaire de distorsions (16).

5. Amplificateur à large bande à transistors suivant les revendications 1 à 4, caractérisé par le fait que les amplifications de tension du premier amplificateur et de l'amplificateur final sont au moins approximativement identiques.

6. Amplificateur à large bande à transistors suivant l'une des revendications 1 à 5, caractérisé par le fait que le premier réseau de contre-réaction (5), réalisé notamment sous la forme d'un correcteur de distorsions à contre-réaction, est formé par un diviseur de tension qui est accouplé par l'intermédiaire d'un transformateur en parallèle à la sortie du préamplificateur (1).

7. Amplificateur à large bande à transistors suivant l'une des revendications 1 à 6, caractérisé par le fait que le correcteur intermédiaire de distorsions (7) est réalisé sous la forme d'un diviseur de tension de telle sorte que pour de basses fréquences, il présente au moins une forte valeur ohmique aussi élevée que dans le cas des fréquences élevées.

0 031 140